# EUROPEAN PATENT APPLICATION

(11) **EP 2 372 785 A1**
(43) Date of publication of application: **05.10.2011**
(21) Application number: 10003681.3
(22) Date of filing: 02.04.2010
(51) Int. Cl.: H01L 31/048, H01L 31/052

(54) **Solar panel with polymer body and method to manufacture such solar panel**

(71) Applicant: Tata Steel Nederland Technology B.V., 1970 CA IJmuiden (NL)
(72) Inventor: Van Krevel, Joost Willem Hendrik, 1970 CA Ijmuiden (NL); Van Beurden, Paul, 1970 CA Ijmuiden (NL); Verdier, Steve, 1970 CA Ijmuiden (NL)
(74) Representative: Blauw, Frans Gerard

(57) **Abstract**

The invention relates to a solar unit comprising one or more solar elements, a substrate and a binding medium, wherein the binding medium connects the one or more solar elements. The solar elements are either positioned in an opening in the substrate, against the substrate or at a distance from the substrate. The solar unit is realised by placing the substrate and solar elements in a mould, providing the necessary electrical connecting means, after which the mould is closed and injected with a binding medium in liquid form.

## Description

The invention relates to a solar panel comprising one or more solar cells. Such solar panels are available in a wide range of embodiments.

These solar panels all have in common that the production thereof is complex and time consuming in the sense that a great number of subsequent steps are needed to complete the final product. For example the production of solar panels using a glass substrate includes laminating in vacuum and this process step needs up to 30 minutes for each solar panel to accomplish the final product. A recently developed alternative method involves heated nip-rollers for initial lamination followed by curing in an autoclave. Here typically polyvinyl butyral (PVB) foil is used as an encapsulation foil, which has the advantage that corrosive acetic acid is not formed in the laminating process. However, also this laminating method needs a process time of up to 20 minutes for each solar panel.

It is an objective of the present invention to provide a solar panel which can be manufactured easily and in a short time.

It is a further objective of the invention to provide a solar panel which can be manufactured against low costs.

It is another objective of the invention to provide a solar panel of sturdy construction.

It is another objective of the invention to provide a lightweight solar panel in comparison with the known solar panels on a glass substrate.

It is another objective of the invention to provide a solar panel in which electronic devices are integrated.

It is another objective of the invention to provide a solar panel in which storing means for electrical energy are integrated.

It is still another objective of the invention to provide a solar panel in which electricity consuming devices are integrated.

According to a first aspect of the invention one or more of the above objectives are realized by providing a solar unit is provided, comprising one or more solar elements, a substrate and electrical connecting means connected to the one or more solar elements, wherein each solar element is attached to the substrate by means of a binding medium and wherein the electrical connecting means are at least partly embedded in the binding medium. In this respect the term "solar element" is a generic term which could mean solar cell, solar panel and like terms for a single or multiple photovoltaic cells.

The combination of substrate with the binding agent provides a rigid body for the one or more solar elements while at the same time providing a secure fixing of the solar elements to said body. Moreover, by using a binding medium the resulting solar unit can be made in considerable less time than the usual solar panels are made and also against less costs.

According to a further aspect of the invention at least one solar element is positioned in an opening in the substrate. With this embodiment a side of the solar element is positioned in or near a plane of the substrate which facilitates the fixing of the solar element to the substrate. By applying the binding medium in a single layer with a certain thickness to a side of the substrate the solar element is fixed to the substrate and at the same time a solar unit of sturdy construction and relatively low weight is realized.

Instead of positioning the solar element in an opening in the substrate according to a further embodiment a solar element is positioned over one or more openings in the substrate. The purpose of positioning the solar elements with respect to the openings in the substrate is that sufficient surface area of a solar element is available to bond with the binding medium. With the positioning of the solar cell over an opening in the substrate the solar cell is against the other side of the substrate than the side from where the binding agent is provided.

According to a further embodiment of the invention the solar elements are positioned at a distance from the substrate and the binding medium is provided between the solar elements and the substrate. This embodiment is especially suitable with profiled substrates which at least partly enclose a three dimensional space, such as for instance a corrugated substrate. With this embodiment openings in the substrate are optionally provided for electrical connecting means and/or for injecting the binding medium from the other side of the substrate with the manufacturing of the solar unit.

According to still a further embodiment of the invention the solar element or elements are embedded in the binding medium wherein the binding medium is a transparent medium. By using a transparent binding medium it is possible to totally embed a solar element in the binding agent. The advantage of a transparent medium is that solar elements can be used that are suitable to receive solar radiation on opposite sides therewith increasing the efficiency of the solar element. These solar elements and the transparent binding medium are used in combination with a substrate shaped such that incoming solar radiation is reflected by the substrate and received by the side of the solar element facing the substrate.

Another advantage of a transparent binding medium is that it forms a protective layer on the solar element.

According to a further aspect of the invention the substrate is preferably a metal plate or metal foil. Such a metal plate in combination with the binding medium provides a rigid body for the solar element which provides a solar unit of less weight relative to common solar panels wherein a glass substrate is used. To further improve the rigidity the metal plate or foil may be profiled in one or more directions. Profiling of the metal plate can also be carried out in such manner that the incoming solar radiation is concentrated on the solar elements and/or is reflected to an opposite side of the solar elements.

To prevent corrosion of the metal plate, the metal plate is preferably provided with a protective coating, for instance a zinc containing coating.

In order to provide a good bonding of the binding medium to the substrate, the substrate is optionally provided with a coating which firmly adheres to the substrate and offers a good base for the binding medium to adhere to.

As an alternative to the metal plate or foil a plastic plate may be used as substrate.

According the invention it is further provided that electrical connecting means are at least partly embedded in the binding medium. By providing that the connecting elements such as wiring to connect solar cells to each other and/or connecting terminals for an outside connection are embedded in the binding medium the connecting elements are protected against adverse environmental and other external influences.

According to a further aspect of the invention it is provided that electronic control means are at least partly embedded in the binding medium. The electronic control means may include any of the common electronic control means for solar panels such as diodes, voltage regulators, inverters and the like. By embedding the necessary control means directly in the binding medium a complete solar unit is realized, which except for an external electrical connection is ready to be used.

Depending on the use of the solar unit the invention further provides an embodiment wherein electrical energy storage means are at least partly embedded in the binding medium. This electrical energy storage means are provided to be able to adapt varying supply and demand of electrical energy or to provide electrical energy at another moment in time than when the solar energy was captured and stored as electrical energy. The electrical storage means, for instance an electrical storage battery or a capacitor, might be embedded completely. However, when using an electrical storage battery, a battery holder might be provided which is accessible from the outside, so as to be able to replace the battery when necessary.

According to still a further aspect of the invention an electrical energy consuming element is at least partly embedded in the binding medium. An electrical energy consuming element is for instance a light source, for instance one or more LED's. With such a solar unit a stand alone product is realized which, if provided with the necessary electronic elements, can serve as light source in the evening hours. The light source is partly embedded in the binding the agent for instance such that the light source is at the opposite side of the solar unit with respect to the front side of the solar cell or cells. With this embodiment the solar unit can for instance be integrated in a roof, the front side of the solar cells being directed to the sun while the light is transmitted to the space beneath the roof. Depending on when the light is needed the solar unit is provided with means to switch the light on or have it switched on by electronic means in dependence of the available amount of daylight.

To realize the desired rigidity of the solar unit and to have enough space to embed all the connecting elements and all other necessary or desired means the binding medium has to have a certain thickness. The thickness of the binding medium may be constant or vary over the surface area of the solar panel dependent on the embedded parts. With profiled substrates, for instance a corrugated substrate like a roof panel, the binding medium may fill at least part of a recession defined by the profile.

According to a further elaboration of the invention the binding medium is a plastic selected from the group consisting of PP, PET, PE, ABS, PMMA, SAN, PC, PA, PU, PUR and copolymers thereof. In tests good results have been realized with PP as a binding medium.

To further improve rigidity or other properties of the plastic used as binding medium additives may be provided, for instance wood, metal and/or ceramic materials. In practice it has turned out that bamboo parts in the plastic helped to improve the UV stability of the plastic.

The size of the solar units and the number of solar cells provided in the solar unit can be chosen as desired. However, it is preferred to manufacture solar units that are easy to handle with respect to weight and size and that have a certain minimal capacity to be able to function as a stand alone device. The solar unit is either a separate unit that can be incorporated in existing building elements, can be easily mounted on building structures or are integrated in advance in building components as for instance corrugated roof panels.

In order to be able to have a larger capacity than that of a single solar units it is provided that solar units can be connected with each other. A simple embodiment consists in that the electrical terminals of each solar unit can be connected by means of external wiring. To this end the solar units are provided with the necessary terminals at the outside, which may be just a negative and positive pole or separate terminals for each solar cell or terminals for combinations of solar cells.

According to a further aspect of the invention it is provided that one or more edges of a solar unit are shaped such as to be able to form a snap connection with a complementary shaped edge of another solar unit, the snap connection between complementary edges forming an electrical and/or a mechanical connection. With a snap connection providing at the same time an electrical and a mechanical connection the solar units can easily and fast be combined into an array of solar units. By providing edges with different positioned positive and negative poles it is possible to arrange the solar units in series and/or parallel in conformance with the specific need. These features are incorporated in the solar unit, however, electrical connecting features can also be incorporated in building components in which one or more solar units are integrated.

According to a further aspect the invention provides a method for producing a solar unit comprising one or more solar elements, a substrate and a binding medium connecting the solar cells to the substrate, comprising the steps of
- providing one or more solar elements and a substrate,
- placing the solar elements and the substrate in a mould,
- applying electrical connecting means,
- injecting a plastic in liquid phase into the mould,
- removing the solar unit from the mould after solidification of the plastic.

The steps of placing the substrate and the solar elements in the mould are dependent on shape of the substrate and whether the substrate is provided with openings to accommodate solar elements. With the solar elements fitting in the openings in the substrate, the substrate is first placed in the mould and thereafter the solar cells in the openings. The electrical connecting means are fixed to the terminals of each of the solar elements in the desired configuration and to any further connecting means or electronic parts, after which the mould is closed and the plastic injected into the mould. With a configuration wherein a solar element is positioned against the substrate, openings in the substrate are needed to be able to form a connection of the binding medium with the solar element and the other side of the substrate than the side facing the solar element. With a configuration in which a solar element is positioned at a distance from the substrate opening in the substrate are needed to inject the binding medium in a liquid phase and/or to use as a feed-through opening for electrical connecting means. In the latter configuration and depending on the shape and size of the substrate the fluid medium could also be injected through injection openings in the mould.

With the configuration wherein the solar element is positioned against the substrate, the solar element does not necessarily have to be placed in the mould but could be later on fixed to the substrate. Fixing could be done by gluing the solar element against the substrate. Also in configurations wherein the plastic has only a small contact area with the solar element through openings in the substrate or even no contact area at all the substrate and solar element may be fixed to each other before being placed in the mould.

With the method according to the invention the solar unit can be easily manufactured against low costs and in a fraction of the time needed for the common solar panels available on the market. The method allows for easy placement of parts in the mould without the need of fixing each and every part to the substrate since the plastic will securely fix all components with respect to each other. Also the wiring does not have to be fixed to the substrate as long as it is fixed to the necessary terminals of solar cells and other components. Only when the solar elements are to be embedded completely in the binding medium it is necessary to provide an at least temporarily support for the solar elements in the mould.

According to a further aspect the method provides that the substrate is formed through the pressure of the plastic liquid phase injected into the mould. By means of this method step the substrate can for instance be formed into a profiled shape for strengthening purposes. The forming step can also be used to form the substrate in a shape suitable for complementary edges of the solar unit and/or as to function as an electrical contact in such complementary edge. In this manner it is not necessary to first form the substrate into a desired shape before it is suitable to be used in the method, therewith further decreasing the time needed for the manufacturing of a solar unit.

Reliable connections between solar cells have been realised with aluminium strip, the strip being provided at one side with an isolation material, which is however only needed if a metal substrate is used. Such an isolation material could be an adhesive isolation material which facilitates the positioning of the electrical connecting means with respect to the solar cells and other parts and the fixing of the electrical connecting means thereto. For a reliable contact the aluminium strip is soldered to the connection points of a solar element.

According to a further aspect of the invention the method includes the steps of at least partly embedding electrical control means and/or electric energy storage means in the binding medium. There is no need to mount the control means and/or electrical energy storage means on the substrate since the binding medium will keep these parts fixed in their respective positions.

According to another aspect of the invention the method includes the step of at least partly embedding an electrical energy consuming element in the binding medium. With such an electrical energy consuming element, for instance a light source, the mould is adapted to provide that the electrical energy consuming element protrudes from the solar panel or has a portion not covered by the binding medium. The mould will be adapted to have the electrical energy consuming element protrude or have a portion not covered by the binding medium. at a side of the solar unit other than the side with the front side of the one or more solar elements. Also possible is to have an electrical energy consuming element protruding or with a portion not covered by the binding medium. at the front side of the solar elements. Depending on the shape of the substrate and the application of the binding medium it could be necessary to provide the substrate with a cut-out to accommodate said electrical energy consuming element. For most embodiments the mould might consist of a relatively simple two-part mould and for some embodiments the substrate can be used as part of the embodiment..

According to a further aspect of the invention the mould is adapted so as to form the substrate under the pressure of the injected binding medium or be suitable to receive an already formed substrate. The substrate may be formed into a shape suitable for one or more shaped edges of the final solar unit such as to be able to form a snap connection with a complementary shaped edge of another solar unit, the snap connection between complementary edges forming a mechanical connection. The mould needed to this end is more complicated and it might be necessary to have a mould consisting of more than two parts.

Preferably it is also provided that electrical connecting means are provided in the shaped edges. The terminals needed for the electrical connection with other solar units are placed in the mould and connected to the electrical connecting means and will be fixed in that position after the curing of the injected binding medium in liquid phase.

According to a further aspect it is provided that the substrate is formed at the edges in such a way that one solar unit fits in the shaped form of the edge of a second solar unit, in this way providing a water proof interconnection between the solar units. This embodiment is particularly suitable when the solar unit is integrated in a building component or where the substrate of the solar unit is adapted to be incorporated in an existing building component such as a roof panel.

If the substrate is a metal plate or foil than as an alternative the substrate can be used as electrical connecting means. By forming and cutting the substrate an extending part thereof could be used as a terminal in the otherwise plastic edge of the snap connection. Likewise by using two separate metal substrates two terminals can be provided in the edge of the snap connection, for instance for respectively the negative and positive pole.

The invention is further elucidated on hand of the non-limitative examples shown in the drawing, wherein:
- fig. 1: shows schematically a solar unit with a number of solar elements,
- fig. 2: shows an array of connected solar units,
- fig. 3: shows schematically a solar unit with a number of solar elements embedded in a transparent binding medium,
- Fig. 4: shows an embodiment with exchangeable components,
- Fig. 5: shows an embodiment with integrated components, and
- Fig. 6: shows an embodiment wherein only some of the components are exchangeable.

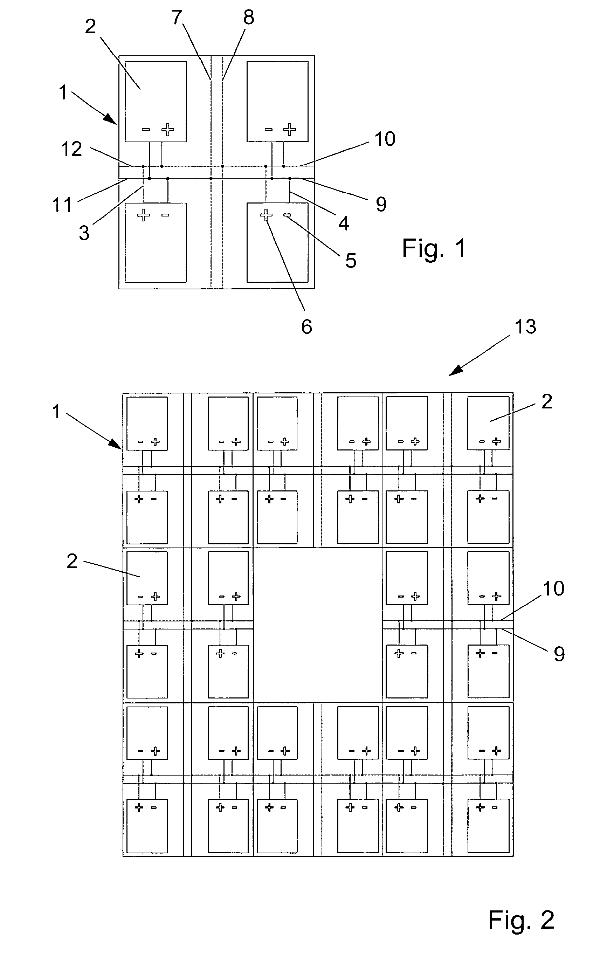

In fig. 1 a solar unit 1 with four separate solar elements 2, such as solar cells, is shown. The individual solar cells 2 are connected by wires or connecting strips 3, 4 respectively connecting the negative and positive terminals 5, 6 of the solar cells to further connection strips or wires 7, 8 and 9, 10. The further connection strips or wires 7, 8 and 9, 10 run in traverse direction to all sides of the solar unit. At the sides the solar unit is provided with negative and positive terminals 11, 12 which easily connect to similar terminals of another solar unit.

The solar cells 2 in the solar unit 1 are connected in parallel. Also possible is to connect in series or in a combination of parallel and in series to get the desired output of the solar unit 1.

Preferably the edges of the solar units are provided with a profile that can engage in a snap connection with a complementary shaped edge of another solar unit. The snap connection realizing a mechanical as well as an electrical connection between the solar units 1.

The solar units are further provided with fastening means, not shown in the drawing, to mount the solar units to a construction.

In fig. 2 on a different scale than in fig. 1 an array 13 of solar units 1 is shown which are connected to each other at the different sides of the solar units 1. Preferably the connection of the solar units 1 to each other is by means of the above snap connection. Since an array with any number of solar units in different configurations can be made, it is very easy to put together just the array which fits the needs and which can also very easy be extended. In addition, diodes, LED's at the back side, battery holders inverters or voltage transformers could be embedded in the binding medium. These are not shown in the drawing.

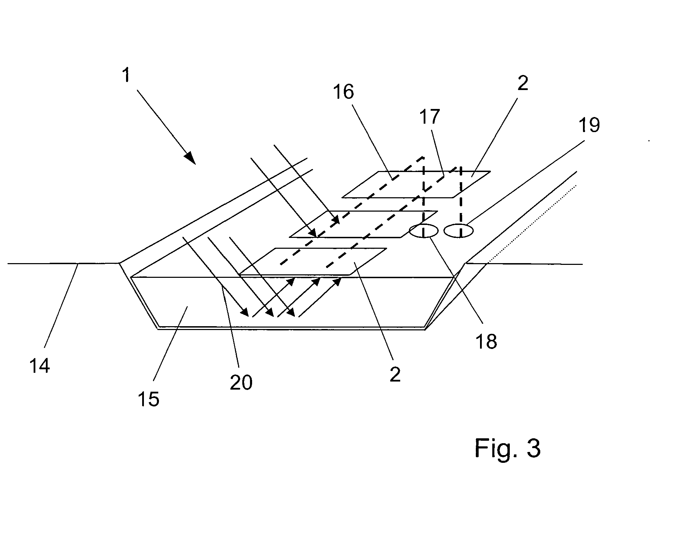

In fig. 3 a solar unit 1 is shown with a substrate 14, a transparent binding medium 15, solar cells 2 embedded in the transparent binding medium and electrical connecting means 16, 17 connected to the poles of the solar cells 2. The substrate 14 is provided with a trapezoidal trench to accommodate the transparent binding medium 15 with solar cells 2. The substrate 14 could be a roof panel with a number of parallel trenched or may have a smaller surface area and for instance be meant to be applied over an existing roof panel with such trenches.

In the substrate 14 openings 18, 19 have been provided as a feed-through opening for the electrical connecting means 16, 17. Although not shown in the drawing also electrical control means could be embedded in the transparent binding medium.

The substrate 14 is preferably provided with a reflecting surface at least in the trench or trenches with the transparent binding medium 15. The combination of reflecting surface of substrate 14, the transparent binding medium 15 and solar cells 2 which are capable of transferring the incoming solar radiation 20 in electrical energy, will result in a higher efficiency than possible with solar cells which only receive solar energy from one side.

With the shown solar unit 1 of fig. 3 the substrate 14 may serve as part of the mould necessary for injecting binding medium 15 in fluid phase. Openings for injecting the binding medium 15 may be provided in the substrate 14 and/or in the other part or parts of the mould. In order to be able to embed the solar cells 2 in the transparent binding medium the solar cells have to be placed on supports in the mould, which supports are preferably also of a transparent material.

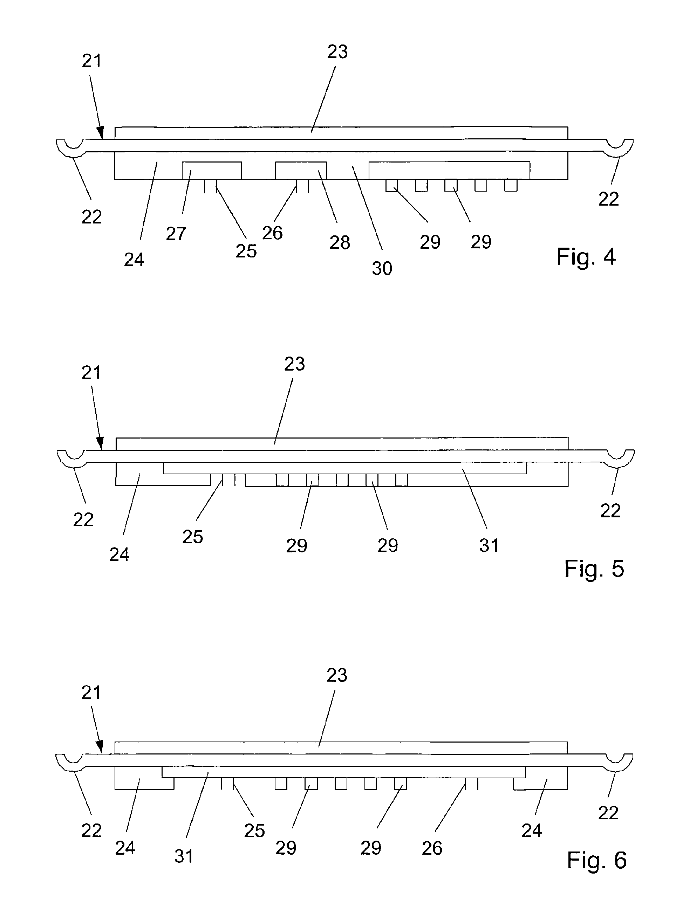

Fig. 4 shows an embodiment of a solar unit with a steel substrate 21 which at opposite edges is provided with bend edges 22. This substrate 21 with edges 22 is to fit in for instance a roof with roof plates with a similar or corresponding profile therewith providing a watertight joint. The edges at the other parts of the circumference of the substrate may be provided with the same or an undulating edge depending on the structure wherein the solar unit is to be built into. At the top side of the solar unit the solar cell 23 is mounted and at the other side of steel substrate 21 embedded in a plastic 24 connecting points 25, 26 for peripheral equipment such as a battery or external electricity consuming equipment. These connecting points are part of a printed circuit board 27, 28. Furthermore, a number of LED's 29 mounted on printed circuit board 30 are provided for direct lighting purposes. The printed circuit boards 27, 28, 30 are interconnected depending on the required functionality.

In this embodiment the printed circuit boards are mounted exchangeable in the plastic which allows for easy replacement in case of malfunction or broken parts. To this end the printed circuit boards are for instance clamped in the plastic or fastened to the substrate 21 for instance by means of one or more snap connections.

Fig. 5 shows an embodiment with a common printed circuit board 31 on which the LED's 29 and connecting points 25 are mounted. The printed circuit board 31 and the LED's 29 are embedded almost completely in the plastic 24, which provides for a durable construction and a nice finish. In this embodiment the printed circuit board 31 lies against substrate 21 as a result of which that at least part of the heat from the LED's 29 is taken up and dissipated by substrate 21.

Fig. 6 shows an embodiment which is an intermediate form of the embodiments according to fig. 4 and fig. 5. This embodiment has a single printed circuit board 31 provided with connecting points 25, 26 and LED's 29 , wherein only the edges of the printed circuit board 31 are embedded in the plastic 24. With this embodiment the LED's 29 can be replaced easily.

## Claims

1. Solar unit comprising one or more solar elements, a substrate and electrical connecting means connected to the one or more solar elements, wherein each solar element is attached to the substrate by means of a binding medium and wherein the electrical connecting means are at least partly embedded in the binding medium.

2. Solar unit according to claim 1, wherein at least one solar element is positioned in an opening in the substrate.

3. Solar unit according to claims 1 or 2, wherein the binding medium acts on at least the side of a solar element facing away from the front side of the solar element.

4. Solar unit according to claim 1 or 2, wherein a solar element is embedded in the binding medium.

5. Solar unit according to one or more of claims 1-4, wherein electronic control means are at least partly embedded in the binding medium.

6. Solar unit according to claim 5, wherein electrical energy storage means are at least partly embedded in the binding medium.

7. Solar unit according to claim one or more of claims 1-6, wherein an electrical energy consuming element is at least partly embedded in the binding medium.

8. Solar unit according to claim one or more of claims 1-7, wherein the substrate is a metal plate or metal foil.

9. Solar unit according to claim one or more of claims 1-8, wherein the binding medium is a plastic selected from the group consisting of PP, PET, PE, ABS, PMMA, SAN, PC, PA, PU, PUR and copolymers thereof.

10. Solar unit according to one or more of claims 1-8, wherein one or more edges of the panel are shaped such as to be able to form a snap connection with a complementary shaped edge of another solar panel, the snap connection between complementary edges forming an electrical and/or a mechanical connection.

11. Method for producing a solar unit comprising one or more solar elements, a substrate and a binding medium connecting the solar cells to the substrate, comprising the steps of
- providing one or more solar elements and a substrate,
- placing the solar elements and the substrate in a mould,
- applying electrical connecting means,
- injecting a plastic in liquid phase into the mould,
- removing the solar unit from the mould after solidification of the plastic.

12. Method according to claim 11, wherein one or more solar elements are positioned with respect to one or more openings in the substrate.

13. Method according to claim 11 or 12, wherein the substrate is formed by means of the pressure exerted by the injected plastic.

14. Method according to claim 11, wherein electrical control means and/or electrical energy storage means are at least partly embedded in the plastic.

15. Method according to one or more of claims 11-13, wherein the mould is adapted so as to form one or more shaped edges of the panel such as to be able to form a snap connection with a complementary shaped edge of another solar panel, the snap connection between complementary edges forming a mechanical connection.
